# EUROPÄISCHE PATENTANMELDUNG

(11) **EP 1 561 843 A2**
(43) Veröffentlichungstag der Anmeldung: **10.08.2005**
(21) Anmeldenummer: 04026971.4
(22) Anmeldetag: 12.11.2004
(51) Int. Cl.: C25D 5/42, C23C 28/00

(54) **Verfahren zur Herstellung von korrosionsbeständigen und dekorativen Beschichtungen und Schichtsystemen für Substrate aus Leichtmetall oder Leichtmetalllegierungen**

(30) Priorität: 07.02.2004 DE 102004006127
(71) Anmelder: Dr.Ing. h.c.F. Porsche Aktiengesellschaft, 70435 Stuttgart (DE)
(72) Erfinder: Separautzki, Reinhold, 71696 Moeglingen (DE); Hentsch, Wolfgang, 01445 Radebeul (DE); Krug, Axel, 01561 Ebersbach (DE)

(57) **Zusammenfassung**

Die Erfindung betrifft ein Verfahren zur Herstellung von korrosionsbeständigen und dekorativen Beschichtungen und Schichtsystemen für Substrate aus Metallen, vorzugsweise Leichtmetallen. Um ein Verfahren zur Herstellung einer Beschichtung und ein Schichtsystem für Substrate aus Metall zu schaffen, mit dem eine dekorative und korrosionsbeständige, hoch belastbare Oberfläche erzeugt werden kann, wird vorgeschlagen, folgenden Schichtaufbau auf das Substrat aufzubringen:
- Haftschicht (z. B. durch Chromatieren)
- Lackschicht
- Plasmaätzprozess zur Vorbehandlung und verbesserten Haftung der Folgeschichten, oder PVD - Schichten aus Oxiden oder Metallen aus gleichem Grund
- PVD-Schichten aus einem Metall oder Metallegierungen
- vorwiegend galvanisch aufgebrachtes Kupfer, Nickel Chrom.

## Beschreibung

Die Erfindung betrifft ein Verfahren zur Herstellung von korrosionsbeständigen und dekorativen Beschichtungen und Schichtsystemen für Substrate aus Metallen, vorzugsweise Leichtmetallen.

Es ist bekannt Fahrzeugräder aus Stahl oder auch aus Leichtmetalllegierungen mit galvanischen Schichten, z.B. Kupfer - Chrom - Nickel, zu versehen.

Beim Galvanikprozess bleiben, insbesondere bei Stahlrädern, in den Fügezonen zwischen Schüssel Felgenbett und, insbesondere bei gegossenen Leichmetallrädern, durch die Kapillarwirkung in den Porositäten Bäderflüssigkeiten aus dem Galvanikprozess haften. In den Fügezonen kommt es außerdem zu keiner durchgängigen Beschichtung. Beides führt später zu Korrosionserscheinungen und zu partiellen Zerstörung der Galvanikschicht. Bei Leichtmetallrädern führt die galvanische Schicht darüber hinaus zu einer unerwünschten Veränderungen der Spannungszustände an der Oberfläche des Rades, was auch Einfluss auf die Funktion und Lebensdauer des Rades haben kann.

Bekannte Galvanikprozesse sind durch die notwendigen Schichtdicken materialaufwändig und führen zu einer spürbar Gewichtserhöhung der beschichteten Räder. So erhöht sich das Gewicht eines Leichtmetall-Rades der Dimension 8J x 17" um durchschnittlich 1 kg aufgrund der zum Oberflächenausgleich benötigten dicken Kupferschichten.

Die DE 196 21861 A1 zeigt ein Verfahren zum Verchromen einer Auto-Felge aus einer Aluminiumlegierung, bei dem auf die Radoberfläche zunächst eine Grundierungsschicht aus Pulver- oder Nasslack aufgebracht wird. Auf diese Grundierungsschicht wird dann eine Schicht aus Galvano-ABS-Kunststoff aufgebracht und anschließend galvanisch verchromt. Die Einsatzgrenzen dieser Beschichtung ergeben sich vor allem aus der begrenzten Temperaturstabilität des Galvano-ABS-Kunststoffs, was eine Ablösung der Beschichtung in thermisch stärker belasteten Zonen des Rades bewirkt.

Aus der DE 198 07 823 A1 ist ein Verfahren zur Herstellung einer korrosionsschützenden Beschichtung und Schichtsystem für Substrate aus Leichtmetall bekannt geworden, bei dem auf das Substrat zunächst eine nicht leitfähige erste Schicht durch einen PVD-Prozess, CVD-Prozess, Lackieren oder anodische Oxidation und Nachverdichten aufgebracht wird. Anschließend wird stromlos eine metallische zweite Schicht aufgebracht. Abschließend wird galvanisch ein Chromschichtsystem mit einer Grundschicht aus Nickel und/oder Kupfer und einer Deckschicht aus Chrom aufgebracht.

Ausgehend von diesem Stand der Technik ist es Aufgabe der Erfindung, ein Verfahren zur Herstellung einer Beschichtung und ein Schichtsystem für Substrate aus Metall zu schaffen, mit dem eine dekorative und korrosionsbeständige, hoch belastbare Oberfläche erzeugt werden kann.

Erfindungsgemäß wird diese Aufgabe mit den Merkmalen der unabhängigen Ansprüche gelöst. Es wird vorgeschlagen, folgenden Schichtaufbau auf das Substrat aufzubringen:
- Haftschicht (z. B. durch Chromatieren)
- Lackschicht
- Plasmaätzprozess zur Vorbehandlung und verbesserten Haftung der Folgeschichten, oder PVD - Schichten aus Oxiden oder Metallen aus gleichem Grund
- PVD-Schichten aus einem Metall oder Metallegierungen
- vorwiegend galvanisch aufgebrachtes Kupfer, Nickel Chrom.

In vorteilhafter Weise wird durch die Haftschicht die Haftung der Lackschicht und damit die Korrosionsbeständigkeit merklich gesteigert. Durch die Lackschicht werden Fügestellen und andere Problemstellen eingeebnet z. B. ausgefüllt und eine durchgängige Beschichtung ermöglicht. Bei Leichtmetallfelgen wird der besondere Vorteil erzielt, dass Porositäten geschlossen werden auf diese Weise ein Eindringen von Prozessflüssigkeiten verhindert ist. Auch ist die Oberfläche des Leichtmetall-Substrats allgemein vor der Einwirkung von Prozessflüssigkeiten geschützt, was zu einem vollständigen Erhalt der Materialeigenschaften führt.

Vorteilhafte Weiterbildungen der Erfindung sind in den Unteransprüchen dargestellt.

Dem eigentlichen Aufbringen des Schichtsystems kann eine mechanische Oberflächenglättung, beispielsweise durch Schleppschleifen, vorgeschaltet sein. Diese Behandlung begünstigt spätere dünnere Nachfolgeschichten und hat damit Einfluss auf das Radgewicht.

Die Haftschicht wird vorzugsweise durch Chromatieren oder Phosphatieren beziehungsweise andere, umweltfreundliche Austauschverfahren (Cr6-frei) aufgebracht.

Die Grundschicht aus Lack kann zum Beispiel aus einem EP-Lack bestehen, der bei 180 °C bis 210 ° eingebrannt wird, um einen hervorragenden Oberflächenverlauf zu erzielen. Die Oberfläche der Grundschicht aus Lack ist bestimmend für die Oberflächengüte des Chromschichtsystems.

Vorzugsweise wird die Oberfläche der Grundschicht aus Lack im Vakuum beispielsweise durch Behandlung mit Plasma unter Zusatz von chemisch aktiven Prozessgasen plasmatechnisch angeätzt. Auf die derart vorbehandelte Oberfläche wird durch plasmatechnisches Beschichten, insbesondere durch ein PVD-Verfahren wie z.B. mittels eines Metall- oder Oxidflash, eine geschlossene Flash-Schicht aufgebracht. Hierzu wird vorzugsweise Chrom verwendet. Die Flash-Schicht unterscheidet sich dadurch von einer Trägerschicht, dass sie weder optisch dicht noch elektrisch leitend sein muss. Beide Maßnahmen - das Anätzen wie auch die Flash-Schicht - dienen der verbesserten Haftfähigkeit der nachfolgenden metallischen Zwischenschicht, die vornehmlich aus Kupfer aber auch aus Nickel oder Nickel - Verbindungen bestehen kann. Mit diesem Verfahren ist eine gleichmäßige, dreidimensionale Beschichtung der Oberfläche bis zu einer Stärke von 20 µm möglich.

Auf die derart hergestellte, elektrisch leitende Zwischenschicht kann nun das abschließende Chromschichtsystem aufgebracht werden.

Hierzu wird vorzugsweise ein gängiger Galvanikprozess verwendet. Als erste Schicht wird hierbei eine Schicht aus Kupfer oder Halbglanznickel bis zu einer Schichtstärke von 150 µm aufgebracht. Auf diese Schicht erfolgt der weitere Aufbau mit Glanznickel, mikroporigem Nickel und danach Chrom. Unter mikroporigem Nickel, in Verbindung mit der Chromschicht auch als mikroporige Verchromung bezeichnet, versteht man eine elektrolytisch aufgebrachte Nickelschicht, die fein verteilte Feststoffe suspendiert enthält. Diese nichtleitenden Teilchen, durch Lufteinblasung im Elektrolyten in Schwebe gehalten, werden in den Niederschlag eingebaut. Bei einer anschließenden Verchromung werden die Einschlüsse nicht verchromt und bilden Mikroporen im Niederschlag. (siehe auch Metzger, W; Ott, R: Galvanotechnik 61 (1970), S. 998 ff.)

Alternativ kann auf die Zwischenschicht eine galvanisch erzeugte Schicht aus Kupfer, Halbglanznickel oder einer Kombination hieraus aufgebracht werden. Weitere galvanisch erzeugte Schichten sind möglich. Als letzte galvanisch aufgebrachten Schicht ist aber eine, mikroporige Nickel-Schicht vorgesehen, auf die in einem PVD-Verfahren die abschließende Chrom-Schicht aufgebracht wird. Diese Kombination ergibt einen erhöhten Korrosionsschutz, der ohne Decklackschicht voll funktionsfähig ist.

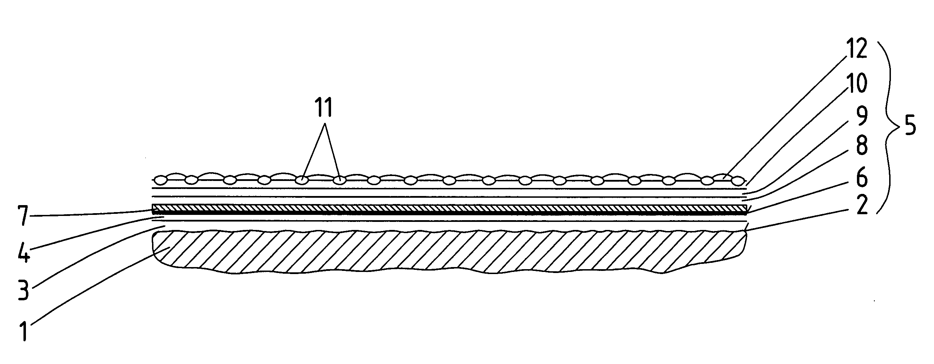

Die Erfindung ist anhand des in der einzigen Figur dargestellten Ausführungsbeispieles näher beschrieben.

Ein Aluminium-Körper, hier eine Felge 1, wurde nach dem Entgraten zunächst durch Schleppschleifen vorbehandelt. Zum Schleppschleifen wurde die Felge in ein Becken mit Schleifkörpern eingetaucht und darin bewegt. Durch das Schleppschleifen wird eine eingeebnete, jedoch nicht polierte Oberfläche erzeugt.

Zum Schichtaufbau wird zunächst als Haftschicht eine Chromatschicht 2 aufgebracht. Auf die Chromatschicht 2 folgt eine Grundlackschicht 3 zum Beispiel aus EP-Lack in einer Dicke von 50 bis 60 µm, der bei 180 °C bis 210 ° eingebrannt wird. Die Grundlackschicht 3 kann ggf. um eine weitere Lackschicht 4 ergänzt werden, insbesondere dann, wenn Nacharbeiten an der Grundlackschicht 3, wie das Überschleifen von Blasen oder Einschlüssen, notwendig geworden sind.

Die Felge 1 ist durch die Lackschichten 3, 4 elektrisch nicht mehr leitend und gegenüber dem Kontakt mit Flüssigkeiten geschützt.

Zur Vorbereitung des Aufbringens eines Chromschichtsystems 5 wird die Felge 1 an der zu beschichtenden Oberfläche angeätzt. Hierzu wird die Felge 1 in einer Vakuumkammer (nicht gezeigt) mit Plasma unter Zusatz von chemisch aktiven Prozessgasen behandelt. Um die Haftfähigkeit weiter zu verbessern wird anschließend durch eine plasmatechnische Beschichtung (zum Beispiel mittels PVD- oder CVD-Verfahren) eine Metallflashschicht 6 aus Chrom aufgebracht. Die Metallflashschicht hat eine Dicke von 5 bis 20 nm.

Durch eine weitere plasmatechnische Beschichtung wird anschließend auf physikalischem Wege eine Kupferschicht 7 mit einer Stärke von circa 0,3 µm aufgebracht, um für die nachfolgenden Galvanikprozesse eine elektrisch leitende Zwischenschicht zu erzeugen.

Auf der so geschaffenen Grundlage wird nun in gängiger Weise das Chromschichtsystem 5 aufgebracht. Auf eine galvanisch erzeugte Kupferschicht 8 mit einer Stärke von 25 µm folgt eine ebenfalls galvanisch aufgebrachte Nickelschicht 9. Eine weitere Nickelschicht 10 ist mikroporig ausgebildet und weist hierzu gewollte Einschlüsse 11 auf, die im Galvanikprozess in Form von suspendierten Festkörpern in den Nickel - Niederschlag eingebaut werden und elektrisch nicht leitend sind. Die Schichtdicke der beiden Nickelschichten 9, 10 beträgt insgesamt 15 µm. Die abschließende Chromschicht 12 weist eine Stärke von 0,3 bis 0,5 µm auf und schließt das Chromschichtsystem 5 ab. Anstelle der galvanisch aufgebrachten Chromschicht 12 ist es auch möglich, die Chromschicht 12 durch ein PVD - Verfahren aufzubringen.

### Bezugszeichenliste

- 1: Felge
- 2: Chromatschicht
- 3: Grundlackschicht
- 4: weitere Lackschicht
- 5: Chromschichtsystem
- 6: Metallflashschicht aus Chrom
- 7: Kupferschicht, plasmatechnisch aufgebracht
- 8: Kupferschicht, galvanisch aufgebracht
- 9: Nickelschicht
- 10: Nickelschicht, mikroporig
- 11: Einschlüsse
- 12: Chromschicht

## Patentansprüche

1. Verfahren zur Herstellung einer hochglänzenden Beschichtung auf Substrate (1) aus Leichtmetall oder Leichtmetalllegierungen mit folgenden Schritten:
- Aufbringen einer Haftschicht (2) auf das Substrat (1)
- Lackieren (3, 4)
- plasmatechnisches Beschichten mit einem Metall (6)
- vorwiegend galvanisches Verchromen (5).

2. Verfahren nach Anspruch 1, **gekennzeichnet durch** eine Vorbehandlung des Substrats (1) **durch** eine mechanische Glättung der Oberfläche, insbesondere **durch** Schleppschleifen.

3. Verfahren nach Anspruch 1, **dadurch gekennzeichnet, dass** das Aufbringen einer Haftschicht (2) ein Chromatieren oder Phosphatieren ist.

4. Verfahren nach einem der Ansprüche 1 bis 3, **dadurch gekennzeichnet, dass** vor dem plasmatechnischen Beschichten (6) die Lackschicht (3, 4) plasmatechnisch angeätzt wird und nach dem plasmatechnischen Beschichten (6) in einem PVD Prozess eine geschlossene Zwischenschicht (7), bestehend aus Metallen, Metallegierungen oder Metalloxiden, aufgebracht wird.

5. Verfahren nach einem der Ansprüche 1 bis 4, **dadurch gekennzeichnet, dass** das galvanische Verchromen aus folgenden Schritten besteht:
- galvanisches Aufbringen einer ersten Schicht (8) aus Kupfer, Halbglanznickel oder einer Kombination hieraus,
- galvanisches Aufbringen wenigstens einer zweiten Schicht (9) aus Glanznickel oder einer mikroporigen Nickelschicht (10), und
- galvanisches Aufbringen einer Schicht (12) aus Chrom.

6. Verfahren nach einem der Ansprüche 1 bis 4, **dadurch gekennzeichnet, dass** das galvanische Verchromen aus folgenden Schritten besteht:
- galvanisches Aufbringen einer ersten Schicht (8) aus Kupfer, Halbglanznickel oder einer Kombination hieraus,
- galvanisches Aufbringen einer mikroporigen zweiten Schicht (10) aus Nickel, und
- PVD-Beschichten (12) mit Chrom.

7. Schichtsystem für Substrate aus Leichtmetall oder Leichtmetalllegierungen, bestehend aus
- einem Substrat (1) aus Leichtmetall oder Leichtmetallegierung
- einer Haftschicht (2)
- einer Grundschicht (3) aus Lack
- einer durch plasmatechnisches Beschichten aufgebrachten metallischen Zwischenschicht (6)
- einem vorwiegend galvanisch aufgebrachten Chromschichtsystem (5).

8. Schichtsystem nach Anspruch 7, **dadurch gekennzeichnet, dass** die Haftschicht (2) aus Chromaten oder Phosphaten besteht.

9. Schichtsystem nach einem der Ansprüche 7 oder 8, **dadurch gekennzeichnet, dass** die metallische Zwischenschicht (6) aus einem Metall oder Metalloxid, insbesondere Chrom, besteht und zwischen der Zwischenschicht (6) und dem Chromschichtsystem (5) eine weitere Zwischenschicht (7) aus Kupfer, Nickel oder einer Legierung dieser Metalle angeordnet ist.

10. Schichtsystem nach einem der Ansprüche 7 bis 9, **dadurch gekennzeichnet, dass** das galvanisch aufgebrachte Chromschichtsystem (5) aus
- einer ersten Schicht (8) aus Kupfer, Halbglanznickel oder einer Kombination hieraus,
- wenigstens einer zweiten Schicht (9) aus Glanznickel und einer mikroporigen Nickelschicht (10) und
- einer Schicht aus Chrom (12) besteht.

11. Schichtsystem nach einem der Ansprüche 7 bis 9, **dadurch gekennzeichnet, dass** das Chromschichtsystem aus
- einer ersten galvanisch aufgebrachten Schicht (8) aus Kupfer, Halbglanznickel oder einer Kombination hieraus,
- einer galvanisch aufgebrachten, mikroporigen zweiten Schicht (10) aus Nickel und
- einer in einem PVD Verfahren aufgebrachten Schicht (12) aus Chrom besteht.
